(19) Europäisches Patentamt
European Patent Office
Office européen des brevets

(11) Numéro de publication: **0 266 832 B1**

(12) **FASCICULE DE BREVET EUROPEEN**

(45) Date de publication de fascicule du brevet: **15.01.92**

(51) Int. Cl.^5: **H03L 7/00**

(21) Numéro de dépôt: **87202058.1**

(22) Date de dépôt: **27.10.87**

(54) **Boucle à verrouillage de phase entièrement numérique.**

(30) Priorité: **31.10.86 FR 8615210**

(43) Date de publication de la demande:
**11.05.88 Bulletin 88/19**

(45) Mention de la délivrance du brevet:
**15.01.92 Bulletin 92/03**

(84) Etats contractants désignés:
**DE FR GB IT SE**

(56) Documents cités:
**EP-A- 0 035 166**
**US-A- 3 777 272**
**US-A- 4 457 003**
**US-A- 4 594 555**

**IEEE TRANSACTIONS ON INDUSTRIAL ELECTRONICS AND CONTROL INSTRUMENTATION, vol. IECI-20, no. 4, novembre 1973, pages 239-251, New York, US; C.P. REDDY et al.: "A class of all digital phase locked loops: Modeling and analysis"**

(73) Titulaire: **THOMSON-TRT DEFENSE**
**88, rue Brillat-Savarin**
**F-75013 Paris(FR)**

(72) Inventeur: **Masson, Jacques Société Civile S.P.I.D.**
**209, rue de l'Université**
**F-75007 Paris(FR)**
Inventeur: **Jeandot, Jean-Louis Société Civile S.P.I.D.**
**209, rue de l'Université**
**F-75007 Paris(FR)**

(74) Mandataire: **Turlèque, Clotilde et al**
**THOMSON-CSF SCPI**
**F-92045 PARIS LA DEFENSE CEDEX 67(FR)**

EP 0 266 832 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

L'invention concerne une boucle à verrouillage de phase entièrement numérique réalisée à l'aide d'un processeur numérique de signal et comportant un échantillonneur-bloqueur suivi d'un convertisseur analogique-numérique et d'un ensemble de filtrage relié à l'entrée d'une logique de décision dont la sortie commande ledit échantillonneur-bloqueur.

Les boucles à verrouillage de phase sont utilisées dans les domaines les plus vastes des télécommunications (radiolocalisation) ainsi qu'en métrologie (synthèse des fréquences). La propriété principale de ces boucles est de permettre la synchronisation sur un signal lors de transmissions bruitées lorsque les moyens classiques de détection sont inopérants face à la faiblesse du signal reçu. Une boucle à verrouillage de phase numérique telle que mentionnée dans le préambule est décrite dans l'article intitulé "Digital Phase-Locked Loop Behaviour with Clock and Sampler Quantization" par Carlos POLAMAZA-RAEZ et Clare D.McGILLEM publié dans IEEE Transactions on Communications, vol.COM-33, N°8, Août 1985, pages 753 à 759.

La boucle de l'invention a été réalisée dans un équipement de cryptophonie pour assurer à la réception la synchronisation de l'échantillonnage du signal numérique de parole brouillé. Dans un tel équipement de cryptophonie réalisant le brouillage par permutations de sous-bandes de fréquence à l'aide d'un traitement numérique, il est fondamental de retrouver en réception la synchronisation exacte des échantillons.

Le but poursuivi est d'obtenir une synchronisation accélérée par utilisation d'une double vitesse de verrouillage permettant une approche rapide en début de convergence puis une approche plus lente et plus précise pour la fin de convergence et le suivi.

Conformément à l'invention ce but est atteint d'une manière optimale à l'aide des dispositions suivantes :

a) Ladite boucle à verrouillage de phase comporte à la suite dudit convertisseur analogique-numérique deux démodulateurs en quadrature fonctionnant à la fréquence de synchronisation et leurs filtres respectifs en sortie desquels un signal y tendant vers zéro après convergence et un signal z permettent de faire fonctionner la boucle en correction forte ou en correction fine selon que la valeur absolue de y est supérieure ou inférieure à une valeur de seuil.

b) Ladite logique de décision effectue la correction de phase d'échantillonnage en retardant ou en avançant l'instant d'échantillonnage par l'ajout ou le retrait d'un certain nombre de cycles "machine" dudit processeur numérique.

c) Un pilote de synchronisation étant inséré à l'émission dans le signal à transmettre, la boucle à verrouillage de phase numérique permet de retrouver une phase d'échantillonnage correcte de ce pilote.

d) L'onde de synchronisation dudit pilote n'étant pas porteuse d'autre information est éliminée par compensation à l'aide de ladite boucle à verrouillage de phase. Cette disposition permet de placer l'onde de synchronisation en n'importe quelle partie de la bande passante notamment en utilisant une fréquence ayant un rapport simple avec la fréquence d'échantillonnage $f_e$ (exemple non limitatif : $f_e/3$, $f_e/4$, etc...).

La description suivante en regard des dessins annexés le tout donné à titre d'exemple fera bien comprendre comment l'invention peut être réalisée.

La figure 1 montre le schéma de principe d'une boucle à verrouillage de phase entièrement numérique conforme à l'invention et fonctionnant à une fréquence de l'onde de synchronisation égale à $f_e/4$.

La figure 2 indique les instants caractéristiques du programme réalisant la boucle.

La figure 3 représente le schéma synoptique du traitement de correction.

Les figures 4, 5, 6 et 7 montrent respectivement les résultats et l'analyse en simulation dans le cas idéal, avec dérive des oscillateurs, avec ajout de bruit et avec bruit et dérive.

La figure 8 montre la modification apportée à la figure 1 dans le cas général où la fréquence de l'onde de synchronisation est égale à $f_e/p$ (p étant un entier supérieur à 2).

Dans la description ci-après, on va présenter l'application de la boucle à verrouillage de phase de l'invention à la synchronisation d'échantillonnage d'un signal numérique brouillé par permutation de sous-bandes de fréquences. Après transmission, ledit signal n'est pas directement exploitable ainsi que le montre l'analyse suivante de sa phase d'échantillonnage.

Soient $x^b(n)$ le signal brouillé numérique émis et $x^{bt}(n)$ le signal brouillé numérique après transmission par le canal analogique.

On suppose que le canal a une réponse impulsionnelle égale à $\delta(t-D)$, c'est-à-dire que le signal numérique à la réception est égal au signal numérique avant transmission retardé de D soit :

$$x^{bt}(n) = x^b(n-D)$$

Pour que le débrouillage se fasse correctement, la valeur de D n'est pas indifférente ; en effet, après analyse du signal x, les signaux de sous-bande $x_0$, $x_1$,..., $x_{N-1}$ correspondant respectivement aux sous-bandes 0, 1,..., N-1 doivent vérifier :

$$x_k^{bt}(m) = x_k^{b}(m-m_0)$$

où $m_0$ est une valeur entière, c'est-à-dire que l'on doit retrouver les signaux de sous-bande tels qu'ils ont été calculés à un retard près. Comme l'échantillonnage des signaux de sous-bande s'effectue à $f_e/N$ ($f_e$ = fréquence d'échantillonnage et N = nombre de sous-bandes), le retard $m_0$ doit être un multiple de NT pour assurer cette propriété ($T = 1/f_e$).

Lors d'évaluations subjectives de la qualité de la parole restituée au débrouilleur de l'équipement de cryptophonie précité, on a constaté que la condition ci-dessus pouvait être réalisée avec une tolérance de ± 5 % de la période T sur la phase d'échantillonnage.

Pour atteindre cet objectif, une boucle à verrouillage de phase entièrement numérique réalisée à l'aide d'un processeur de signal a été étudiée. Cette boucle dont le schéma de principe est représenté sur la figure 1, comporte les éléments constitutifs suivants:

- un échantillonneur-bloqueur 1 et un convertisseur analogique-numérique 2,
- deux démodulateurs en quadrature (cosinus et sinus) 3 et 4 et leurs filtres associés 5 et 6 fournissant respectivement les signaux y et z,
- une logique de décision 7 permettant de faire la correction de phase d'échantillonnage.

Le signal z provenant du démodulateur 4 est retranché en 8 du signal reçu afin d'éliminer par compensation la porteuse de synchronisation.

L'ensemble des éléments 3 à 8 est rassemblé dans le processeur de signal 9.

La correction de phase d'échantillonnage s'effectue autour de la valeur de fréquence libre (fe) par l'ajout ou le retrait d'un certain nombre de cycles "machine" dudit processeur.

Le réglage dans le temps du programme réalisant la boucle est illustré par la figure 2 sur laquelle les commandes d'échantillonnage agissant directement sur l'échantillonneur-bloqueur sont indiquées par les flèches $S_i$ (i = 1, 2, 3...) et l'acquisition des échantillons par les flèches $s_i$ (i = 1, 2, 3...).

Entre deux commandes successives d'échantillonnage, on trouve deux zones de durées fixes : une zone de latence $A_i$ (i = 1, 2, 3 ...) pour l'acquisition de l'échantillon et une zone $B_i$ (i = 1, 2, 3...) où s'effectue le calcul de la correction à appliquer pour chaque échantillon introduit à l'entrée de la boucle. Cette zone de correction est suivie d'une zone "tampon" $C_i$ (i = 1, 2, 3...) de durée variable selon le résultat dudit calcul de correction.

Ainsi par exemple, pour une période d'échantillonnage de 125 $\mu$s (fe = 8 kHz) et pour un temps de cycle de processeur de 200 ns, on aurait un espacement de 125/0,2 = 625 cycles "machine" entre deux commandes successives d'échantillonnage si ladite correction était nulle c'est-à-dire si les fréquences du signal avant et après transmission étaient identiques. Ces fréquences étant différentes, le processeur élabore une correction et selon la valeur de cette correction un certain nombre d'unités sera retranché des 625 cycles "machine" calculés ci-dessus ou leur sera ajouté de façon à avancer ou à retarder la commande d'échantillonnage suivante.

On a ainsi remplacé la tension variable d'un VCO dans une boucle à verrouillage de phase analogique par une variation de cycles "machine" dans la boucle à verrouillage de phase numérique.

Pour simplifier au maximum les traitements, on a choisi fo = fe/4 comme fréquence de l'onde de synchronisation. Ce choix n'est pas limitatif et il sera expliqué ci-après les traitements réalisés lorsque la fréquence de l'onde de synchronisation est $f_e/p$, p étant un entier supérieur à 2.

Un signal pour lequel $f_0 = f_e/4$ peut être représenté sous forme numérique par la suite +A, 0, -A, 0, +A, 0, ... où A représente l'amplitude crête de l'onde de synchronisation. A la réception,

$$\sin\left(\frac{2\pi f_e t}{4}\right)$$

peut être représenté par la suite 0, +1, 0, -1, 0, +1, ... après échantillonnage à $f_e$, et

$$\cos\left(\frac{2\pi f_e t}{4}\right)$$

peut être représenté par la suite +1, 0, -1, 0, +1, 0, ...,
ce qui simplifie particulièrement les opérations de démodulation.

Si l'onde de synchronisation est échantillonnée avec une erreur de phase $\phi$, ladite onde peut être représentée par la suite $A\sin(2\pi \times n\, fe/4\, T + \phi) = A\sin(n\, \pi/2 + \phi)$ où n est un indice courant désignant le numéro de l'échantillon considéré.

La suite des échantillons est la suivante : $A\sin\phi$, $A\cos\phi$, $-A\sin\phi$, $-A\cos\phi$, $A\sin\phi$,..., ce qui donne les suites suivantes :
en sortie du démodulateur 4 :
v(n) = 0, $A\cos\phi$, 0, $A\cos\phi$, 0,...
en sortie du démodulateur 3 :
u(n) = $A\sin\phi$, 0, $A\sin\phi$, 0, $A\sin\phi$,...
En sous-échantillonnant les sorties des démodulateurs et en ne gardant que les instants significatifs, c'est-à-dire en ignorant les multiplications par les zéros des démodulateurs, ces deux suites deviennent respectivement $A\cos\phi$, $A\cos\phi$, $A\cos\phi$,... et $A\sin\phi$, $A\sin\phi$, $A\sin\phi$,...

Lors de la convergence de la boucle, la valeur de $\phi$ tendra vers 0, et lesdites suites tendront respectivement vers A, A, A,... et 0, 0, 0,...

A l'aide des signaux de sortie des cellules de filtrage situées après les démodulateurs (signaux appelés y et z), il est possible de faire fonctionner la boucle selon deux modes : acquisition rapide mais grossière, fin de convergence et suivi selon le schéma synoptique de la figure 3.

Sur ce synoptique, les fonctions d'échantillonnage et de conversion analogique-numérique du signal d'entrée x(t) représentées de manière distincte par 1 et 2 sur la figure 1 sont regroupées ici dans le bloc 1,2 indiquant en outre que seules les valeurs non nulles des échantillons sont exploitées et transmises aux démodulateurs locaux 3 et 4.

Les signaux u(n) et v(n) issus de ces démodulateurs sont ensuite filtrés à l'aide des filtres 5 et 6 passe-bas récursifs du premier ordre dont la réponse est donnée par :

$$H(Z) = \frac{\lambda_i}{1 - (1-\lambda_i)Z^{-1}}$$

où $\lambda_i$ (i = 5 ou 6) caractérise la bande passante du filtre : plus $\lambda_i$ est faible, plus la bande passante est étroite (en pratique, $\lambda_5 \approx 1/256$ et $\lambda_6 \approx 1/64$, ce qui produit un filtrage plus énergique en 5 qu'en 6).

En sortie des filtres numériques, on trouve les signaux y(n) et z(n). Les signaux u(n), y(n), z(n) vont servir à déterminer la correction à appliquer. En cas d'erreur de phase statique (ou variant lentement vis à vis des fréquences de coupure des filtres 5 et 6), y(n) tend vers $A\sin\phi$ et z(n) tend vers $A\cos\phi$.

|y(n)| est d'abord comparé à un seuil défini par : seuil = $\alpha z(n)$, ($\alpha \approx 1/4$).

- si |y(n)| est supérieure au seuil, (N), cela signifie que le déphasage $\phi$ est important, et l'on va appliquer une forte correction (COFO) de la phase d'échantillonnage, cette correction consistant en une variation de 10 temps de cycle machine, le sens de la correction étant déterminé par le signe de u(n) :
  = si u(n)<0 ($\phi$ négatif), l'instant d'échantillonnage est retardé par l'ajout de 10 temps de cycles, ce qui tend à augmenter algébriquement $\phi$, donc à le rapprocher de zéro.
  = si u(n)>0 ($\phi$ positif), l'instant d'échantillonnage est avancé, ce qui tend encore à rapprocher $\phi$ de 0.
- si|y(n)| est inférieure au seuil, (Y), il est décidé d'appliquer une correction fine (COFI) de l'instant d'échantillonnage, qui consiste à faire varier ce dernier de un temps de cycle machine tous les p échantillons y(n) (exemple : p = 8, ou 16, ou 32 suivant la rapidité de correction désirée), le sens de la correction étant encore déterminé par le signe de u(n).

Il n'est pas effectué de correction sur la valeur du signal z(n), comme indiqué (NOCO) sur le schéma synoptique de la figure 3.

Le comportement de la boucle en simulation a été analysé dans le cas idéal (voir figure 4).

Sur la figure 4a on a tracé l'évolution de l'erreur de phase de l'échantillonnage $\phi$ lors de l'acquisition, en fonction de n, l'échantillon considéré.

On a porté sur la figure 4b un agrandissement de la courbe précédente entre $\pm 4{,}5^\circ$ représentant

l'écart de ± 5 % que l'on peut tolérer sur la période d'échantillonnage.

La figure 4c montre l'évolution des grandeurs |y| et du seuil $\alpha z.(\alpha = 1/4)$. L'intersection des deux courbes correspond à l'instant de commutation entre approche rapide et approche lente.

A la mise en route de la boucle numérique, l'erreur de phase $\phi$ est de -135° ; un processus de convergence rapide s'engage, matérialisé par la partie linéaire de la figure 4a. Lorsque l'on atteint la phase 0, un deuxième processus s'engage, matérialisé sur les figures 4a et 4b par des oscillations autour de 0, provoquées par des corrections fortes affectées du signe de u(n). La phase $\phi$ restant toutefois autour de 0, y(n) qui correspond à un filtrage énergique de $A\sin\phi$ va se rapprocher de zéro, et un troisième processus débute lorsque l'on atteint |y(n)|< seuil, ce processus étant la convergence finale à l'aide de corrections fines, ce qui est matérialisé par la partie quasi-linéaire de la figure 4b, suivie d'oscillations de faible amplitude au voisinage de zéro, produites par la quantification des corrections.

Les figures 5a et 5b montrent une convergence dans le cas d'un décalage ($5.10^{-5}$ en valeur relative) de fréquence libre entre l'onde de synchronisation et l'échantillonnage. Les oscillations plus grandes de la phase autour de zéro sont produites par la nécessité de corriger la fréquence locale en permanence.

Les figures 6a et 6b présentent le comportement de la boucle en présence de bruit mais sans décalage des fréquences libres, le rapport signal à bruit étant de 28 dB. Grâce aux filtrages énergiques réalisés par les filtres 5 et 6, le bruit n'influence que très peu la phase d'échantillonnage après convergence.

Les figures 7a et 7b montrent une convergence en présence de bruit et d'un décalage des fréquences libres (rapport signal à bruit : 28 dB, décalage des fréquences : $5.10^{-5}$ en valeur relative).

Le comportement de la boucle est encore acceptable avec 20 dB de rapport signal à bruit et $10^{-4}$ de dérive

La précision de convergence permet de plus la suppression par compensation de la porteuse de synchronisation en sortie du dispositif. En effet, il s'agit de soustraire au signal reçu une onde sinusoïdale échantillonnée dont la phase est très proche de zéro, et dont l'amplitude est approximée par z(n) [$z(n) = A\cos\phi \# A$ quand $\phi \# 0$]. Par soustraction de la suite 0, +A, 0, -A,... à la suite des échantillons reçus, on soustrait ainsi une sinusoïde

$$A\sin\left(\frac{2\pi n f_e T}{4}\right),$$

qui constitue une bonne approximation de

$$A\sin\left(\frac{2\pi n f_e T}{4} + \varphi\right)$$

lorsque $\phi$ est très près de 0. Si $|\phi|$ est inférieur à 4,5° le résidu d'onde de synchronisation est affaibli d'au moins 22 dB par rapport à l'onde initiale, ce qui permet de choisir éventuellement une fréquence située dans la bande passante du canal (exemple : $f_e/4$, $f_e/3$, etc..).

La boucle entièrement numérique ainsi réalisée présente les caractéristiques principales suivantes :

- une acquisition rapide (≈ une centaine de périodes d'échantillonnage)
- un suivi correct en présence de perturbations (bruit-dérive) - une réalisation simple sur processeur de signal.
- une très bonne compensation de l'onde servant à la synchronisation.

La boucle à verrouillage fonctionne de façon tout à fait analogue lorsque la fréquence de synchronisation est égale, non plus à $f_e/4$, mais à $f_e/p$ ($p>2$, $p \neq 4$). Dans ce cas le schéma de principe de la boucle à verrouillage de phase représenté sur la figure 1 doit être modifié conformément au schéma de la figure 8 en disposant devant les filtres récursifs 5 et 6 les filtres transverses 10 et 11 respectivement, comme il va être expliqué ci-après pour p = 3 à titre d'exemple non limitatif.

L'onde de synchronisation échantillonnée peut être représentée par

$$A\sin\left(\frac{2n\pi f_e}{3} T + \varphi\right) = A\sin\left(\frac{2n\pi}{3} + \varphi\right).$$

Les démodulateurs 3 et 4 utilisent respectivement les signaux :

$$\cos\left(\frac{2n\Pi f_e}{3}T\right) = 1,\ -1/2,\ -1/2,\ 1,\ldots$$

$$\text{et}\quad \sin\left(\frac{2n\Pi f_e}{3}T\right) = 0,\ +\sqrt{3}/2,\ -\sqrt{3}/2,\ 0,\ +\sqrt{3}/2,\ldots$$

Les suites des états en sortie de 3 et 4 sont respectivement :
u(n) : $A\sin\phi$, $-1/2\ A\sin(\phi+2\Pi/3)$, $-1/2\ A\sin(\phi+4\Pi/3)$,...
v(n) : 0, $\sqrt{3}/2\ A\sin(\phi+2\Pi/3)$, $-\sqrt{3}/2\ A\sin(\phi+4\Pi/3)$,...

On constate des variations d'amplitude périodiques de fréquence $f_e/3$ (le même type de variations existait dans le cas p = 4, avec :
u(n) = $A\sin\phi$, 0, $A\sin\phi$,...
v(n) = 0, $A\cos\phi$, 0,...
mais elles étaient éliminées par le sous-échantillonnage).

Ces variations d'amplitude sont éliminées à l'aide de filtres transverses 10 et 11 à p (= 3 dans notre exemple) coefficients égaux à 2/p (= 2/3 dans notre exemple).

Les filtres calculent respectivement :

$$u'(n) = \frac{2}{3}(u(n) + u(n-1) + u(n-2))$$
$$= \frac{2}{3}\left[A\sin\varphi - \frac{1}{2}\left(A\sin\left(\varphi - \frac{2\Pi}{3}\right) + A\sin\varphi\left(\varphi - \frac{4\Pi}{3}\right)\right)\right]$$
$$= A\sin\varphi$$

$$\text{et}\quad v'(n) = \frac{2}{3}(v(n) + v(n-1) + v(n-2))$$
$$= \frac{2}{3}\left[0 + \frac{\sqrt{3}}{2}\left(A\sin\left(\varphi - \frac{2\Pi}{3}\right) - A\sin\left(\varphi - \frac{4\Pi}{3}\right)\right)\right]$$
$$= A\cos\varphi$$

On est donc ramené au cas précédent, à condition d'utiliser u'(n) au lieu de u(n) dans le calcul de la correction. Lorsque l'asservissement converge, y(n) tend vers 0 et z(n) tend vers A, ce qui rend encore possible la compensation de l'onde de synchronisation par soustraction au signal reçu de la suite 0, Asin $2\Pi/p$, Asin $4\Pi/p$, Asin $6\Pi/p$,...

## Revendications

1. Boucle à verrouillage de phase entièrement numérique réalisée à l'aide d'un processeur numérique de signal (9) et comportant un échantillonneur-bloqueur (1) suivi d'un convertisseur analogique-numérique (2) et d'un ensemble de filtrage (5,6) relié à l'entrée d'une logique de décision (7) dont la sortie commande ledit échantillonneur-bloqueur, caractérisé en ce que ladite boucle à verrouillage de phase comporte à la suite dudit convertisseur analogique-numérique deux démodulateurs en quadrature (3 et 4) fonctionnant à la fréquence de synchronisation et leurs filtres respectifs (5 et 6) en sortie desquels un signal y tendant vers zéro après convergence et un signal z permettent de faire fonctionner la boucle en correction forte ou en correction fine selon que la valeur absolue de y est supérieure ou égale à une valeur de seuil.

2. Boucle à verrouillage de phase selon la revendication 1, caractérisée en ce que ladite logique de décision effectue la correction de phase d'échantillonnage en retardant ou en avançant l'instant d'échantillonnage par l'ajout ou le retrait d'un certain nombre de cycles "machine" dudit processeur numérique.

3. Boucle à verrouillage de phase selon la revendication 1, caractérisée en ce qu'un pilote de synchronisation étant inséré à l'émission dans le signal à transmettre, ladite boucle numérique permet de retrouver une phase d'échantillonnage correcte dudit pilote.

4. Boucle à verrouillage de phase selon la revendication 3, caractérisée en ce que l'onde de synchronisation dudit pilote est ensuite éliminée par compensation à l'aide de ladite boucle, ce qui permet de situer dans la bande passante la fréquence de ce pilote de telle façon qu'elle soit dans un rapport simple avec la fréquence d'échantillonnage.

## Claims

1. An entirely digital phase-locked loop realized by means of a digital signal processor (9) and comprising a sample-and-hold circuit (1) followed by an analog-digital converter (2) and by a filter set (5, 6) connected to the input of a decision logic (7) whose output drives said sample-and-hold circuit, characterized in that said phase-locked loop comprises two quadrature demodulators (3 and 4) operating at the synchronization frequency and being connected to the output of said analog-digital converter, and their respective filters (5 and 6), from the outputs of which a signal y tending towards the zero level after having achieved convergence and a signal z allow to cause the loop to operate in the coarse correction mode or in the fine correction mode, depending on whether the absolute value of y is higher than or equal to a threshold level.

2. A phase-locked loop according to claim 1, characterized in that said decision logic performs the sampling phase correction by delaying or advancing the sampling instant through adding or subtracting a certain number of "machine" cycles of said digital processor.

3. A phase-locked loop according to claim 1, characterized in that on the transmission end, a synchronization pilot signal is inserted into the signal to be transmitted, so that the digital loop makes it possible to retrieve a correct sampling phase of said pilot signal.

4. A phase-locked loop according to claim 3, characterized in that the synchronization wave of said pilot signal is subsequently eliminated by way of compensation via said loop, so that the frequency of said pilot signal is located in the passband in such a way that its ratio to the sampling frequency is a simple one.

## Patentansprüche

1. Phasenverriegelungsschleife in voll digitalisierter Form, die mit Hilfe eines digitalen Signalprozessors (9) aufgebaut ist, mit Tast- und Haltekreis (1) und nachgeschaltetem Analog-Digital-Wandler (2), sowie einem Filtersatz (5, 6), der an den Eingang einer Entscheidungslogik (7) angeschlossen ist, deren Ausgang den Tast- und Haltekreis steuert, dadurch gekennzeichnet, daß die Phasenverriegelungsschaltung im Anschluß an den Analog-Digital-Wandler zwei mit der Synchronisationsfrequenz arbeitende Demodulatoren (3 und 4) in Phasenquadratur und ihre jeweiligen Filter (5 und 6) aufweist, an deren Ausgängen ein nach Konvergenz gegen Null strebendes Signal y und ein Signal z den Betrieb der Schleife im groben Korrekturmodus oder im Feinkorrekturmodus ermöglichen, je nachdem, ob der Absolutwert von y größer als ein Schwellenwert ist oder diesem gleicht.

2. Phasenverriegelungsschleife nach Anspruch 1, dadurch gekennzeichnet, daß die Entscheidungslogik die Tastphasenkorrektur durch Verzögern oder Vorverlegen des Tastzeitpunkts mittels Zugabe oder Wegnahme einer bestimmten Anzahl von "Maschinenzyklen" des digitalen Prozessors bewirkt.

3. Phasenverriegelungsschleife nach Anspruch 1, dadurch gekennzeichnet, daß ein Synchronisationspilotsignal bei der Aussendung in das zu übertragende Signal eingefügt wird, so daß die digitale Schleife das Wiederauffinden einer korrekten Tastphase des Pilotsignals ermöglicht.

4. Phasenverriegelungsschleife nach Anspruch 3, dadurch gekennzeichnet, daß die Synchronisationswelle des Pilotsignals anschließend durch Kompensation mit Hilfe der Schleife eliminiert wird, wodurch die Frequenz des Pilotsignals derart im Durchlaßbereich plaziert wird, daß sie in einem einfachen Bezugsverhältnis zur Tastfrequenz steht.

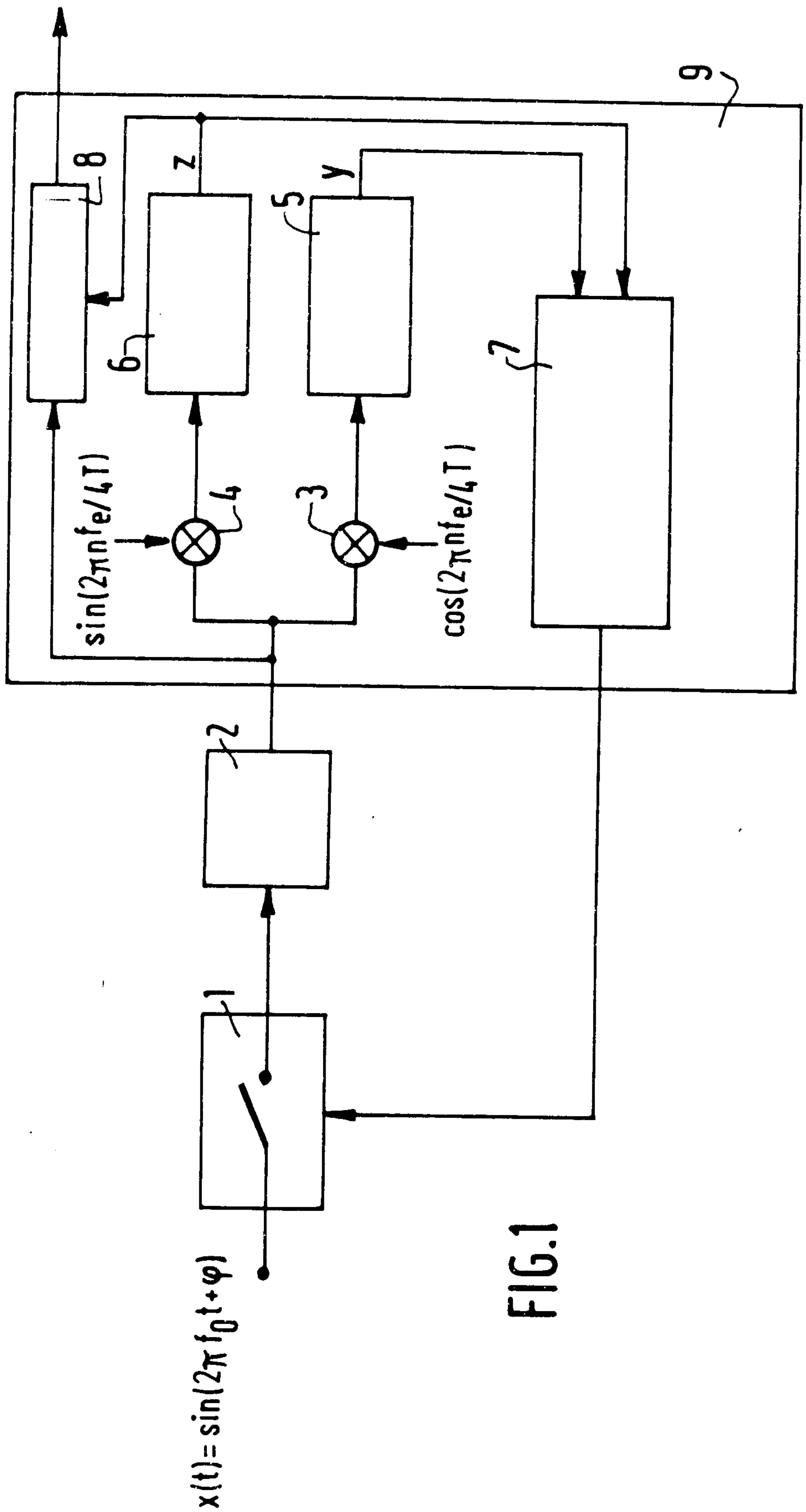


FIG.1

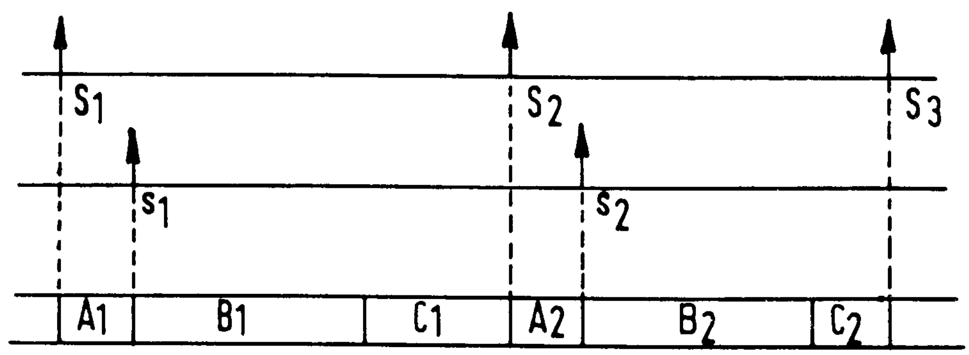
S1
S2
S3
s1
s2
A1
B1
C1
A2
B2
C2

FIG.2

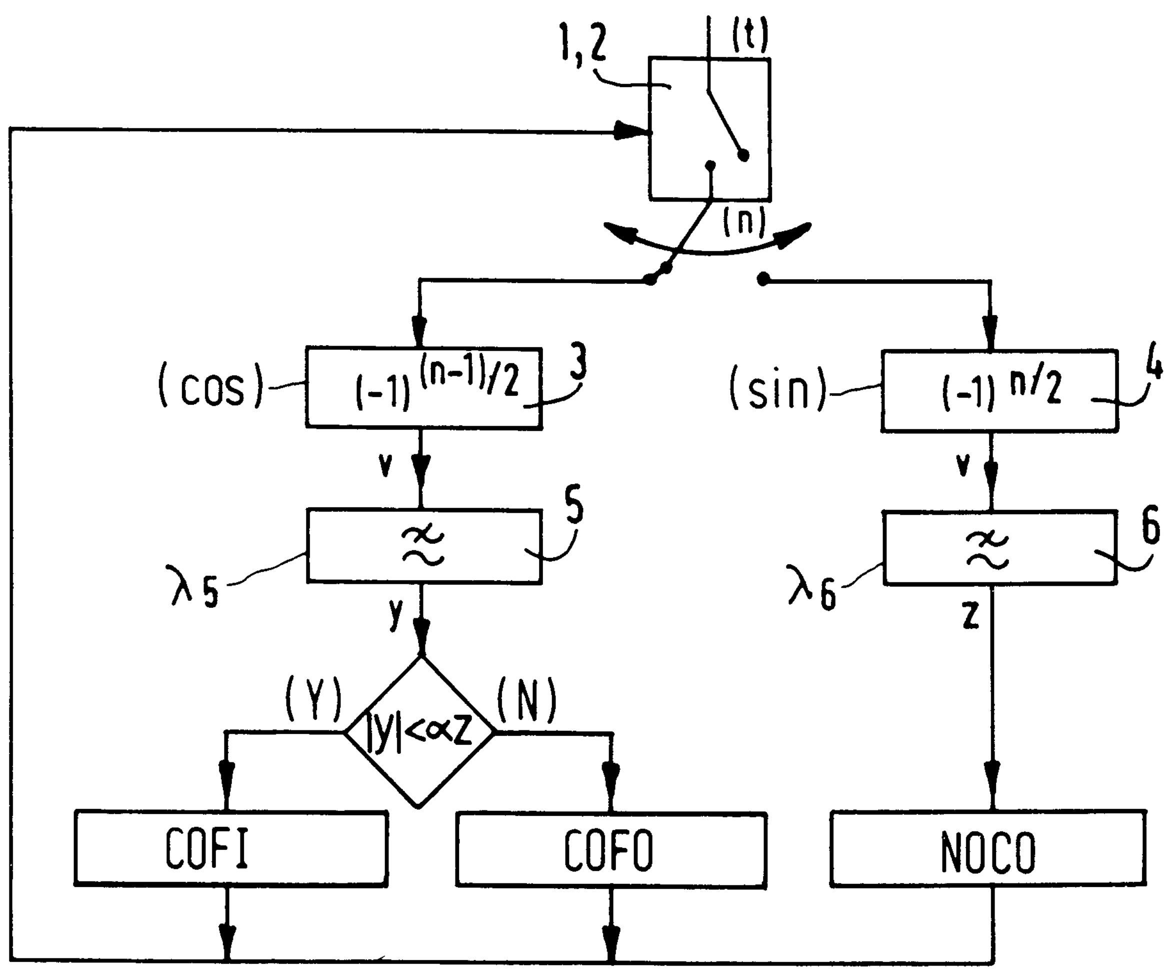
1,2
(t)
(n)
(cos)
(-1) (n-1)/2
3
(sin)
(-1) n/2
4
v
5
6
λ5
λ6
y
z
(Y)
(N)
|y|<αz
COFI
COFO
NOCO

FIG.3

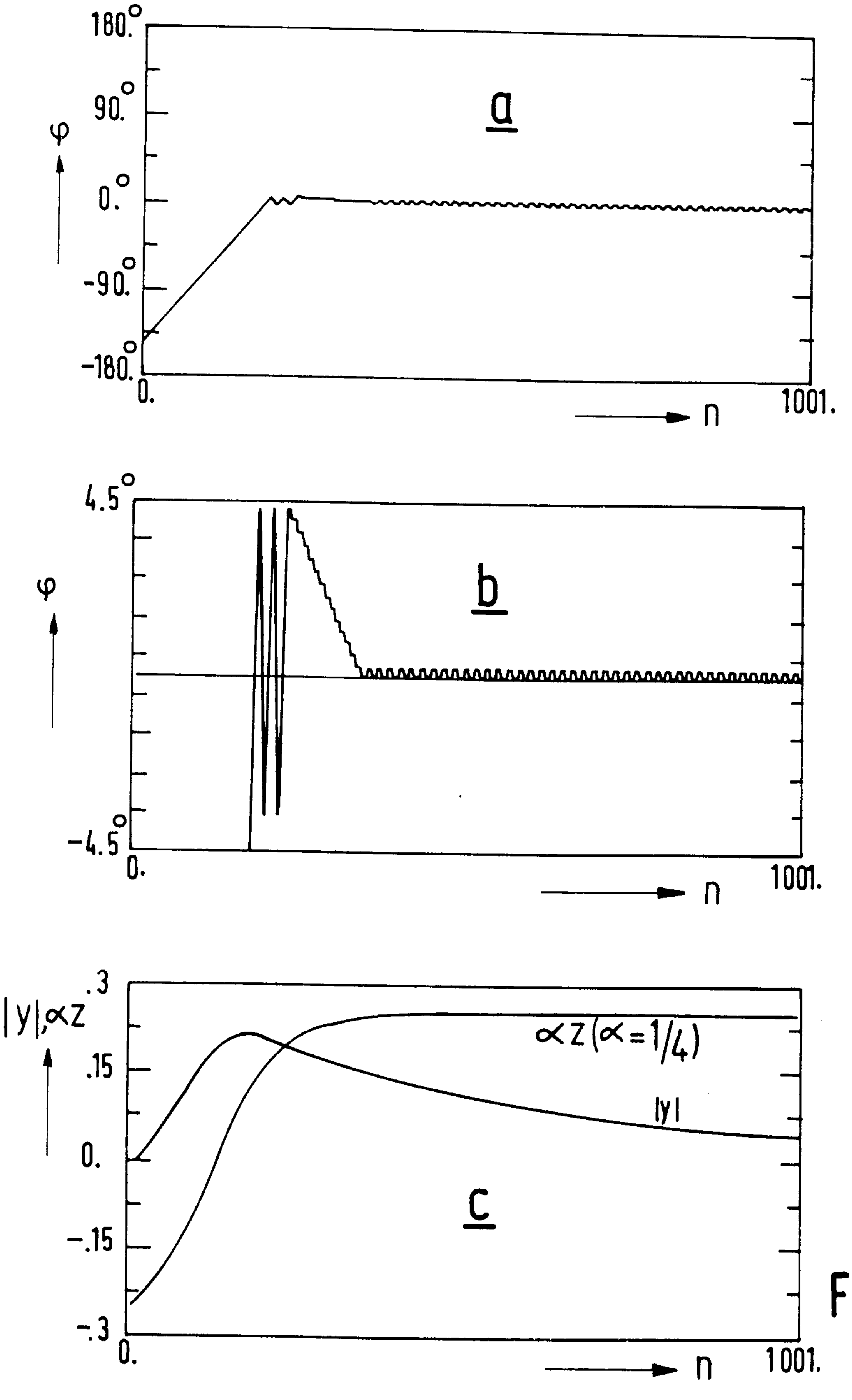
180.°
90.°
0.°
-90.°
-180.°
φ
a
0.
1001.
n
4.5°
-4.5°
φ
b
0.
1001.
n
.3
.15
0.
-.15
-.3
|y|,∝z
∝z(∝=1/4)
|y|
c
0.
1001.
n

FIG.4

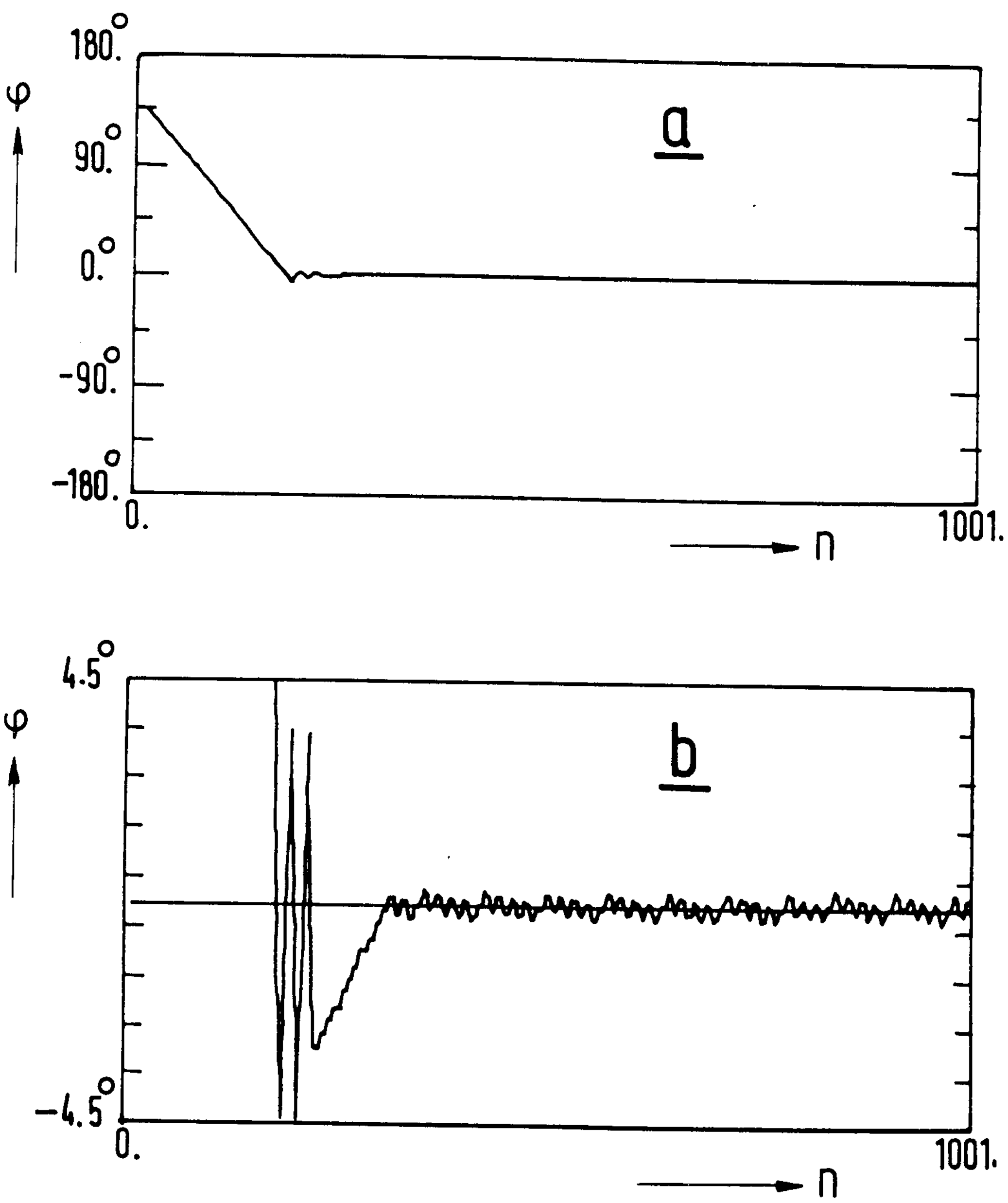


FIG.5

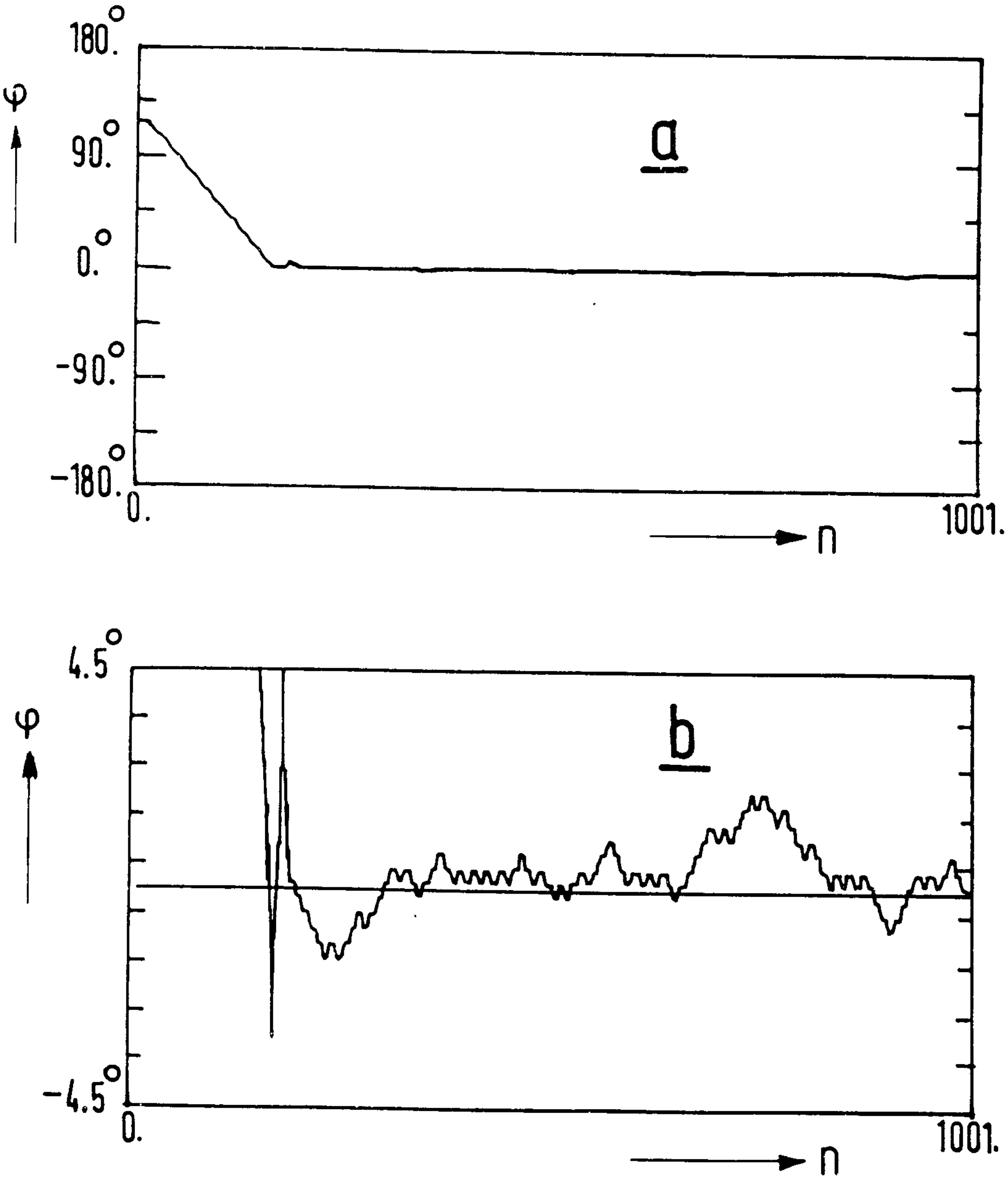


FIG.6

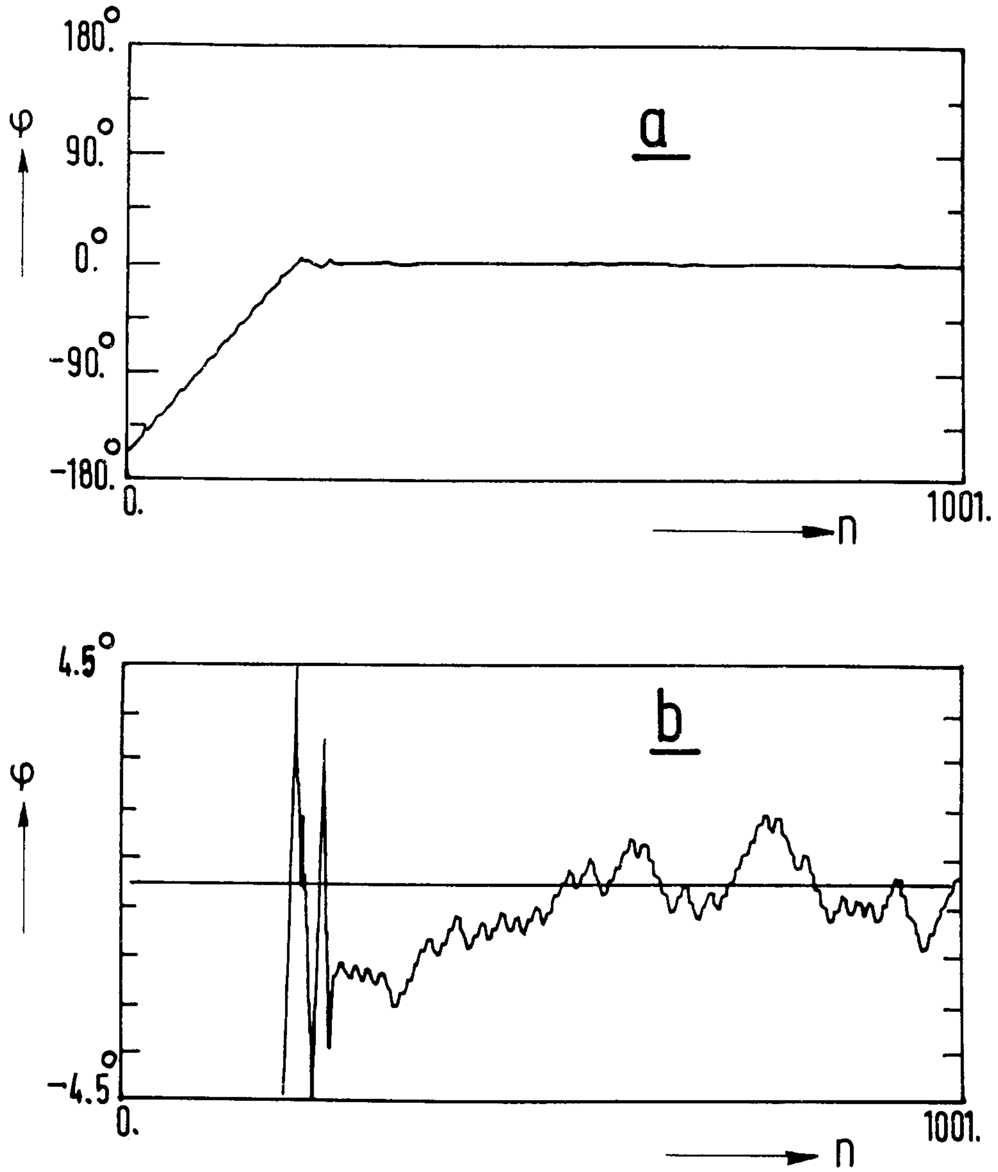
180°
90°
0°
-90°
-180°
φ
a
0.
1001.
n
4.5°
-4.5°
φ
b
0.
1001.
n

FIG.7

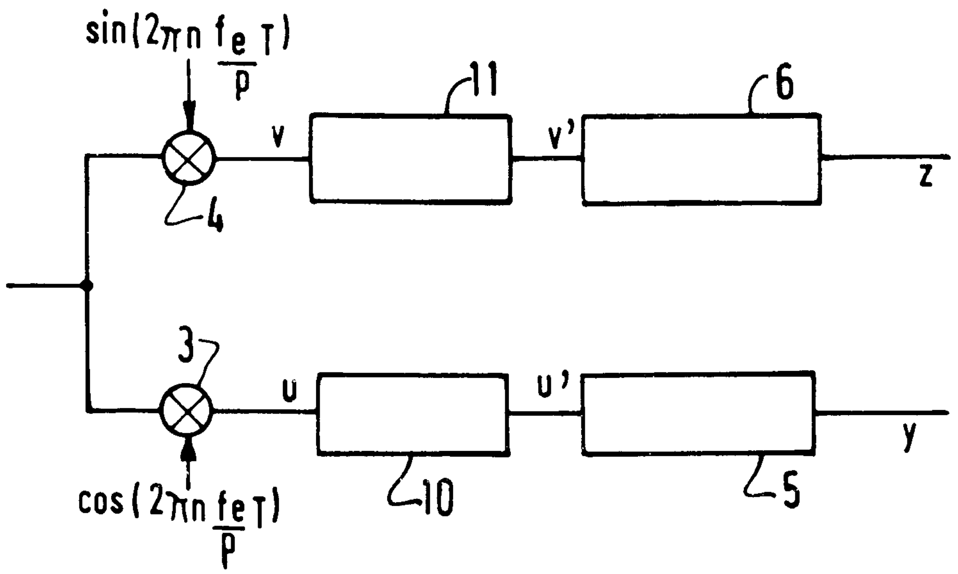
sin(2πn fe/p T)
cos(2πn fe/p T)
4
3
v
11
v'
6
z
u
10
u'
5
y

FIG.8